# EUROPÄISCHE PATENTSCHRIFT

(11) **EP 4 393 277 B1**
(45) Veröffentlichungstag und Bekanntmachung des Hinweises auf die Patenterteilung: **30.07.2025**
(21) Anmeldenummer: 22753601.8
(22) Anmeldetag: 01.08.2022
(51) Int. Cl.: A62C 3/16, A62C 99/00, H05K 5/02

(54) **SCHALTSCHRANKANORDNUNG MIT EINEM GEHÄUSE, EINEM DARIN AUFGENOMMENEN ELEKTROCHEMISCHEN ENERGIESPEICHER UND EINER LÖSCHANLAGE**
SWITCH CABINET ASSEMBLY COMPRISING A HOUSING, AN ELECTROCHEMICAL ENERGY STORE ACCOMMODATED THEREIN, AND AN EXTINGUISHING SYSTEM
ENSEMBLE ARMOIRE DE COMMANDE COMPRENANT UN BOÎTIER, ACCUMULATEUR D'ÉNERGIE ÉLECTROCHIMIQUE LOGÉ DANS LE BOÎTIER, ET SYSTÈME D'EXTINCTION

(30) Priorität: 27.08.2021 DE 102021122271
(43) Veröffentlichungstag der Anmeldung: 03.07.2024
(73) Patentinhaber: Rittal GmbH & Co. KG, 35745 Herborn (DE)
(72) Erfinder: MUELLER, Philipp, 57258 Freudenberg (DE); MÜLLER, Barbara, 57567 Daaden (DE); WIRTH, Andreas, 35080 Bad-Endbach (DE); WEBER, Markus, 65620 Waldbrunn (DE)
(74) Vertreter: Angerhausen, Christoph
(86) Internationale Anmeldenummer: PCT/DE2022/100553
(87) Internationale Veröffentlichungsnummer: WO 2023/025346

(56) Entgegenhaltungen:
- CN-A- 112 421 406
- CN-U- 207 085 120

## Beschreibung

Die Erfindung geht aus von einer Schaltschrankanordnung mit mindestens einem Gehäuse und mindestens einem darin aufgenommenen elektrochemischen Energiespeicher und einer ebenfalls in dem Gehäuse aufgenommenen Löschanlage. Eine derartige Schaltschrankanordnung ist in der EP 2 076 317 B1 beschrieben. Eine ähnliche Schaltschrankanordnung beschreibt auch die DE 10 2006 010 360 B3. Eine Schaltschrankanordnung mit den Merkmalen des Oberbegriffs des Anspruchs 1 ist aus der CN 112 421 406 A1 bekannt. Eine ähnliche Schaltschrankanordnung beschreibt die CN 207 085 120 U.

Bei IT-Anwendungen wird zur Absicherung der Energieversorgung von Servern häufig eine sogenannte unterbrechungsfreie Stromversorgung (USV) mit elektrochemischen Energiespeichern, wie Batterien oder Akkumulatoren eingesetzt. Diese elektrochemischen Energiespeicher müssen nach der Norm DIN EN 62485-2 belüftet werden. Zusätzlich kommt für den Brandschutz eine Löschanlage zum Einsatz. Für den kompakten Aufbau werden häufig beide Systeme in demselben Gehäuse angeordnet. Wenn die Löschanlage auslöst, strömt ein Löschgas aus und flutet das Gehäuse. Um eine für die optimale Brandhemmung ausreichend hohe Konzentration des Löschgases in dem Gehäuse zu gewährleisten, ist es erforderlich, dass der Schrank möglichst fluidisch dicht ausgebildet ist. Andererseits ist eine möglichst gute Abdichtung des Gehäuses bzw. der Schaltschrankanordnung zur Umgebung hin ebenfalls erforderlich, um eine gewünschte IP-Schutzklasse zu erreichen.

Demgemäß steht das Belüftungserfordernis nach DIN EN 6248-2 in Konkurrenz zu der für die Aufrechterhaltung der Löschgaskonzentration und die Erzielung einer hohen IP-Schutzklasse erforderlichen Dichtheit des Gehäuses. Zur Lösung dieser Problematik sind aus dem Stand der Technik elektrisch ansteuerbare Verschlussklappen in Außenwänden des Gehäuses bekannt, die jedoch eine aufwendige elektrische Ansteuerung erfordern. Darüber hinaus weisen diese elektrisch ansteuerbaren Verschlussklappen eine vergleichsweise hohe Bautiefe auf, mit der sie in das Gehäuse hineinragen, und sind kostenintensiv.

Es ist daher die Aufgabe der Erfindung, eine Schaltschrankanordnung bereitzustellen, die einerseits die für die Bestückung mit Batterien erforderliche Belüftung des Innenraums bereitstellt und andererseits im Brandfall gewährleistet, dass das das Gehäuse flutende Löschgas mit einer ausreichend hohen Konzentration für die optimale Brandhemmung aufrechterhalten wird.

Diese Aufgabe wird durch eine Schaltschrankanordnung mit den Merkmalen des Anspruchs 1 gelöst. Vorteilhafte Ausführungsformen der Erfindung sind Gegenstand der abhängigen Ansprüche.

Demgemäß ist vorgesehen, dass an mindestens zwei Außenwänden des mindestens einen Gehäuses diametral gegenüberliegend jeweils mindestens eine gasdurchlässige Membran angeordnet ist, über die eine Gasatmosphäre im Innern des mindestens einen Gehäuses mit einer Gasatmosphäre in der Umgebung des mindestens einen Gehäuses fluidisch in Verbindung steht. Die Gasdurchlässigkeit der Membran, beispielsweise ihre Porosität, ist so eingestellt, dass ein Gas eines Löschmittels, welches im Vergleich zum Wasserstoff (viel) größere Moleküle aufweist, nicht durch die Membran hindurchtreten kann. Dies wiederum bedingt, dass auch Flüssigkeiten, insbesondere Wasser nicht durch die Membran hindurchtreten können. Die Porosität ist beispielsweise über die Dichte und den Öffnungsquerschnitt einer Vielzahl Fibrillen der Membran einstellbar.

Es kann beispielsweise eine erste Membran an einer untersten Stelle und eine zweite Membran an einer obersten Stelle eines Gehäuses, beispielsweise eines Schaltschranks, einer unterbrechungsfreien Stromversorgung (USV) oder eines Kühlgeräts (Liquid Cooling Package - LCP) angeordnet werden. Auf diese Weise kann ein diagonaler Luftstrom durch natürliche, potentielle Druckunterschiede entstehen. Die Membran kann dazu eingerichtet sein, Luft durchzulassen und im Übrigen zu verhindern, dass Wasser durch sie eindringt, womit eine hohe IP-Schutzklasse der Schaltschrankanordnung gewährleistet wird. Im Übrigen kann die Membran dazu eingerichtet sein, die gegenüber Luft und Wasserstoff vergleichsweise sehr langkettigen organischen Moleküle eines gasförmigen Löschmittels zu blockieren und somit vor dem Austreten aus der Schaltschrankanordnung im Brandfall hindern. Eine geeignete Membran ist in der EP 2 404 652 B1 beschrieben. Die Membran kann Bestandteil eines Druckausgleichsstopfens sein. Ein geeigneter Druckausgleichsstopfen wird unter der Handelsbezeichnung PMF 200542 von der Firma W.L. Gore Associates GmbH vertrieben.

Demgemäß können die gasdurchlässigen Membranen durchlässig für zumindest Wasserstoffgas (H₂) und undurchlässig für Flüssigkeit, insbesondere für Wasser, sein. Darüber hinaus können die gasdurchlässigen Membranen eine zumindest im Vergleich zu der Durchlässigkeit für das Wasserstoffgas stark herabgesetzte Durchlässigkeit aufweisen. Diese Differenzierung bei der Durchlässigkeit ist insbesondere deshalb möglich, weil das Wasserstoffgas einerseits eine sehr geringe Molekülgröße aufweist und andererseits die Löschgase häufig langkettige (organische) Moleküle sind.

So kann bei einer Ausführungsform der Erfindung die Membran ein mikroporöses expandiertes Polytetrafluorethylen (ePTFE) aufweisen oder daraus bestehen. Die Porengröße der Membran kann demgemäß gerade derart eingestellt sein, dass einerseits eine gute Durchlässigkeit für Wasserstoffgas und andererseits eine demgegenüber stark herabgesetzte Durchlässigkeit für die vergleichsweise viel größeren Moleküle des Löschgases bereitgestellt ist. Darüber hinaus ist durch eine Einstellung der Porengröße in der zuvor beschriebenen Weise sichergestellt, dass die Membran auch undurchlässig für Flüssigkeit, insbesondere für Wasser ist.

Beispielsweise kann die gasdurchlässige Membran eine Vielzahl Fibrillen mit einem Durchmesser aufweisen, der um ein Vielfaches geringer als der Durchmesser eines Wassertropfens ist, mit dem die Schaltschrankanordnung und insbesondere die Membran im Anwendungsfall beaufschlagt werden könnte, beispielsweise wenn die Schaltschrankanordnung der Witterung ausgesetzt ist.

Die mindestens eine Membran kann jeweils bei einem Überdruck von 10-12 mbar im Innern der Schaltschrankanordnung gegenüber der Umgebung der Schaltschrankanordnung eine Gasdurchlässigkeit für Luft von mindestens 14 l/min aufweisen.

Die gasdurchlässige Membran kann für Wasserstoffgas (H₂) durchlässig und für ein Löschgas der Löschanlage, vorzugsweise für langkettige Kohlenstoffverbindungen, besonders bevorzugt für das Gas des Perfluor(2-methyl-3-pentanon) (C₆F₁₂O) im Wesentlichen undurchlässig sein. Die hohe Differenz in der Gasdurchlässigkeit zwischen dem Wasserstoff und dem Löschgas ist insbesondere dadurch realisierbar, dass bereits geringe Differenzdrücke >0 mbar ausreichen, um die Öffnungen der Membran ausreichend groß für Wasserstoffmoleküle zu weiten. Selbst bei einem maximalem Druckstoß des Löschgases im Auslösemoment der Löschanlage, konnte experimentell kein signifikantes Abfallen der Konzentration des Löschgases detektiert werden. Die Gasdurchlässigkeit ist mithilfe eines manometrischen Verfahrens bestimmbar.

Beispielsweise kann die Gasdurchlässigkeit (Permeabilität) für Wasserstoffgas (H₂) mindestens 5 mal, vorzugsweise mindestens 10 mal größer als für das Löschgas, insbesondere für C₆F₁₂O, sein.

Die gasdurchlässige Membran kann in einem fluidischen Übergang eines Druckausgleichsventils angeordnet sein. Das Druckausgleichsventil kann beispielsweise als der zuvor beschriebene Druckausgleichsstopfen ausgebildet sein.

Der fluidische Übergang kann vom Innern des mindestens einen Gehäuses zur Umgebung des mindestens einen Gehäuses gasdurchlässig und in entgegengesetzter Richtung gasundurchlässig sein.

Die Schaltschrankanordnung kann mehrere Gehäuse aufweisen, die eine Schaltschrankreihe aus fluidisch untereinander verbundenen Gehäusen bildet. Die Gehäuse können ein Schaltschrankgehäuse und/oder ein Kühlgerätegehäuse und/oder eine unterbrechungsfreie Stromversorgung und/oder ein anderes im Schaltschrankbau übliches Gehäuse sein, welches in eine Schaltschrankreihe integriert werden kann. Dabei können die beiden mikroporösen Membranen in der Außenwand unterschiedlicher Gehäuse der Schaltschrankreihe angeordnet sein.

Das Löschmittel kann Perfluor(2-methyl-3-pentanon) sein oder aufweisen. Als langkettige Molekül wird es von der Membran zurückgehalten oder nur stark verzögert durchgelassen, sodass im Brandfall eine Mindestkonzentration des Löschmittelgases im Gehäuse für eine für Löschzwecke erforderliche Dauer aufrechterhalten wird.

Die Löschanlage kann eine Löschmitteldosierung aufweisen, die dazu eingerichtet ist, im Löschfall eine Menge Löschmittel, vorzugsweise Perfluor(2-methyl-3-pentanon), in das Innere der Schaltschrankanordnung zu dosieren, die im Innern des mindestens einen Gehäuses einen atmosphärischen Überdruck gegenüber der Umgebung der Schaltschrankanordnung von mindestens 25 mbar, vorzugsweise mindestens 35 mbar und besonders bevorzugt von mindestens 40 mbar erzeugt.

Die Membran kann dazu eingerichtet sein, den Überdruck, vorzugsweise zu mindestens 80%, für mindestens 3 Minuten zu halten, vorzugsweise für mindestens 5 Minuten und besonders bevorzugt für mindestens 12 Minuten.

Eine Konzentration des Löschmittels in der Atmosphäre im Gehäuse kann im Löschfall mindestens 5 %, bevorzugt mindestens 6 % und besonders bevorzugt mindestens 8 % betragen, wobei die Membran dazu eingerichtet ist, die Konzentration, vorzugsweise zu mindestens 80%, für mindestens 3 Minuten zu halten, vorzugsweise für mindestens 5 Minuten und besonders bevorzugt für mindestens 12 Minuten.

Im Innern des Gehäuses kann ein Prallblech einem Löschmittelauslass der Löschanlage vorgelagert angeordnet sein. Das Prallbech kann dazu eingerichtet sein, die Verteilung des Löschgases im Innern der Schaltschrankanordnung zu verbessern.

Weitere Einzelheiten der Erfindung werden anhand der nachstehenden Figuren erläutert. Dabei zeigt:
- Figur 1: eine erste Ausführungsform einer erfindungsgemäßen Schaltschrankanordnung; und
- Figur 2: eine zweite Ausführungsform einer erfindungsgemäßen Schaltschrankanordnung.

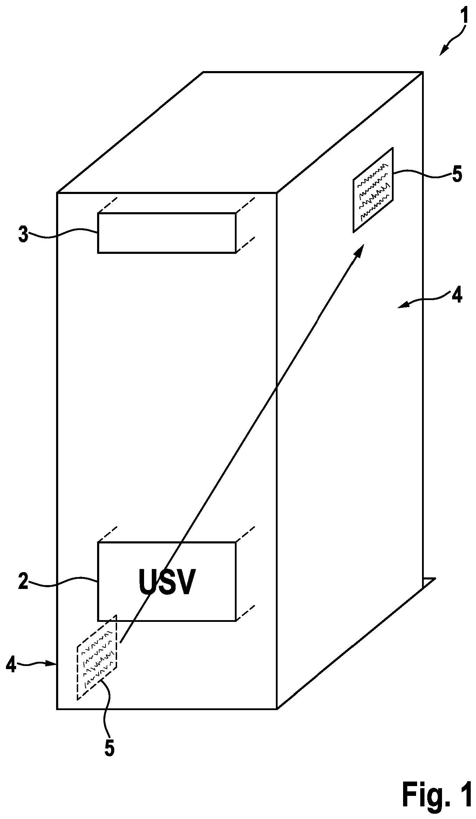

Die Figur 1 zeigt eine ersten beispielhafte Ausführungsform einer erfindungsgemäßen Schaltschrankanordnung, die aus einem einzelnen Gehäuse 1, beispielsweise aus einem Schaltschrankgehäuse besteht. In dem Schaltschrankgehäuse sind neben den nicht dargestellten Komponenten einer elektrischen Schaltanlage oder Servereinbauten einer IT-Umgebung weiterhin eine unterbrechungsfreie Stromversorgung (USV) 2 sowie eine Löschanlage 3 angeordnet. Eine beispielhafte Löschanlage ist in allen Details in der EP 2 076 317 B1 beschrieben. Die Löschanlage 3 ist dazu eingerichtet, infolge einer detektierten Brandentwicklung im Schaltschrankinnern das Schaltschrankgehäuse mit einem Löschgas zu fluten. Um ausreichende Löschwirkung zu entfalten, ist sicherzustellen, dass das Löschgas über eine ausreichende Zeitdauer mit einer ausreichenden Konzentration im Innern des Schaltschrankgehäuses aufrechterhalten bleibt. Dazu ist es wesentlich, dass das Innere des Schaltschrankgehäuses im Wesentlichen fluidisch dicht zur Umgebung des Schaltschrankgehäuses 1 ausgebildet ist.

Die für die Brandbekämpfung erforderliche Gasdichtheit steht im Widerspruch zu der gesetzlich vorgeschriebenen Belüftung von Gehäusen, die Batterien enthalten, beispielsweise eine USV 2. Das Belüftungserfordernis steht weiterhin in Konkurrenz zu dem für elektrische Schaltanlagen und IT-Umgebungen bestehenden Erfordernis der Erreichung einer möglichst hohen IP-Schutzklasse.

Zur Lösung dieser Problematik schlägt die Ausführungsform gemäß Figur 1 vor, dass an gegenüberliegenden Seitenwänden 4 des Schaltschrankgehäuses 1 diametral gegenüberliegend jeweils eine Membran 5 angeordnet ist, die durchlässig für Ausgasungen der USV im Versagensfall, jedoch ausreichend undurchlässig für ein Löschgas der Löschanlage 3 ist. Wenn die Membran 5 undurchlässig für ein Löschgas der Löschanlage 3 ist, ist sie auch undurchlässig für Flüssigkeiten, insbesondere Wasser, um die angestrebte IP-Schutzklasse zu erreichen.

Die Membranen 5 weisen einen maximalen Abstand innerhalb des Schaltschrankgehäuses zueinander auf, um eine möglichst hohe Druckdifferenz für die natürliche Durchlüftung des Schaltschrankgehäuses zu ermöglichen. Demgemäß ist eine erste Membran in einem unteren Bereich der Seitenwand an der Vorderseite des Gehäuses 1 angeordnet, während eine zweite Membran 5 an der gegenüberliegenden Seitenwand 4 einem oberen Ende dieser und an einer Rückseite des Gehäuses 1 angeordnet ist. Die Membranen 5 können beispielsweise als ein Druckausgleichsfilter ausgebildet sein, wie er beispielsweise in der EP 2 404 652 B1 beschrieben ist.

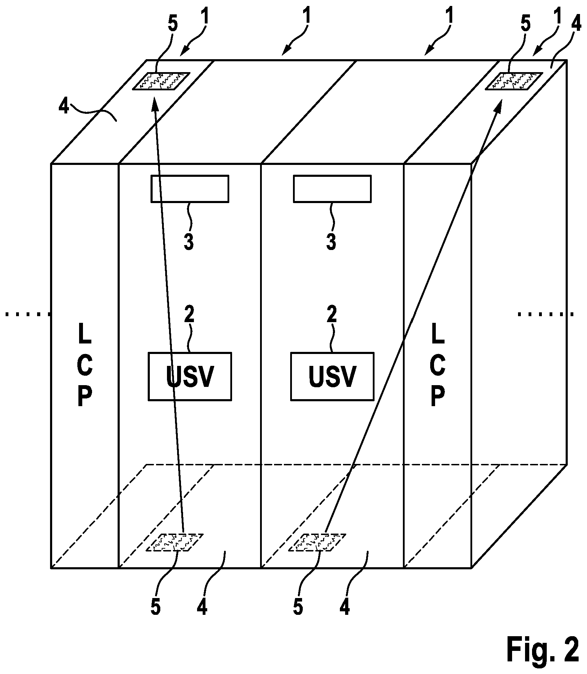

Die Figur 2 zeigt eine Schaltschrankanordnung, die eine Schaltschrankreihe bildet, bestehend aus zwei zentralen Gehäusen 1, die jeweils eine USV 2 und eine Löschanlage 3 aufweisen und außenseitig an diese angrenzend jeweils ein Gehäuse 1 mit einem Kühlgerät (Liquid Cooling Package - LCP). Bei dieser Ausführungsform verteilen sich die Membranen 5 auf die verschiedenen Gehäuse 1, wobei erkennbar jedes Gehäuse 1 nur eine Membran 5 aufweist. Zwei erste Membranen 5 für den Lufteinlass sind im Boden der USVs 2 angeordnet, während zwei zweite Membranen 5 im Dachelement der LCP-Gehäuse 1 angeordnet sind. Aufgrund natürlicher Temperaturschwankungen kann mit Hilfe dieser Anordnung der Membranen eine natürliche Durchlüftung der Schaltschrankanordnung erreicht werden, analog zu der Einzelgehäuseanordnung gemäß Figur 1.

Die beschriebenen Lösungen haben den Vorteil, besonders platzsparend und kostengünstig nachrüstbar zu sein. Über die Membranen kann ein kontinuierlicher Luftaustausch zwischen dem Schaltschrankinnern und der Umgebung stattfinden. Da Wasserstoff (H₂) das kleinste Molekül ist, wird dieser bei der Ausgasung aus den Batterien der USVs 2 und einer damit verbundenen Druckerhöhung im Schaltschrankinnern direkt abgeführt, sodass kein explosives Gemisch im Schaltschrankinneren entstehen kann.

Die Membranen 5 erlauben es weiterhin, dass im Brandfall nach der Auslösung der Löschanlage 3 eine ausreichend lange Haltezeit des Löschmittels im Innern der Schaltschrankanordnung gewährleistet wird.

Die in der vorstehenden Beschreibung, in der Zeichnung sowie in den Ansprüchen offenbarten Merkmale der Erfindung können sowohl einzeln als auch in beliebiger Kombination für die Verwirklichung der Erfindung wesentlich sein.

### Bezugszeichenliste

- 1: Gehäuse
- 2: Energiespeicher
- 3: Löschanlage
- 4: Außenwand
- 5: Membran

## Patentansprüche

1. Schaltschrankanordnung mit mindestens einem Gehäuse (1) und mindestens einem darin aufgenommenen elektrochemischen Energiespeicher (2) und einer Löschanlage (3), wobei an mindestens zwei Außenwänden (4) des mindestens einen Gehäuses (1) diametral gegenüberliegend jeweils mindestens eine gasdurchlässige Membran (5) angeordnet ist, über die eine Gasatmosphäre im Innern des mindestens einen Gehäuses (1) mit einer Gasatmosphäre in der Umgebung des mindestens einen Gehäuses (1) fluidisch in Verbindung steht, wobei eine Gasdurchlässigkeit der Membran so eingestellt ist, dass ein Gas eines Löschmittels der Löschanlage (3), welches im Vergleich zum Wasserstoff größere Moleküle aufweist, nicht durch die Membran hindurchtreten kann.

2. Schaltschrankanordnung nach Anspruch 1, bei der die gasdurchlässigen Membranen (5) durchlässig für zumindest Wasserstoffgas (H₂) und undurchlässig für Flüssigkeit, insbesondere Wasser, sind.

3. Schaltschrankanordnung nach Anspruch 1 oder 2, bei der die Membran (5) ein mikroporöses expandiertes Polytetrafluorethylen (ePTFE) aufweist oder daraus besteht.

4. Schaltschrankanordnung nach einem der vorangegangenen Ansprüche, bei der die gasdurchlässige Membran (5) eine Vielzahl Fibrillen mit einem Durchmesser aufweist, der um ein Vielfaches geringer als der Durchmesser eines Wassertropfens ist.

5. Schaltschrankanordnung nach einem der vorangegangenen Ansprüche, bei der die mindestens eine Membran (5) jeweils bei einem Überdruck von 10-12 mbar im Innern der Schaltschrankanordnung gegenüber der Umgebung der Schaltschrankanordnung eine Gasdurchlässigkeit für Luft von mindestens 14 l/min aufweist.

6. Schaltschrankanordnung nach einem der vorangegangenen Ansprüche, bei der die gasdurchlässige Membran (5) für Wasserstoffgas (H₂) durchlässig und für ein Löschgas der Löschanlage (3), vorzugsweise für langkettige Kohlenstoffverbindungen, besonders bevorzugt für das Gas des Perfluor(2-methyl-3-pentanon) (C₆F₁₂O) im Wesentlichen undurchlässig ist.

7. Schaltschrankanordnung nach Anspruch 1, bei der die Gasdurchlässigkeit für Wasserstoff mindestens 5 mal, vorzugsweise mindestens 10 mal größer als für das Löschgas ist.

8. Schaltschrankanordnung nach einem der vorangegangenen Ansprüche, bei der die gasdurchlässige Membran (5) in einem fluidischen Übergang eines Druckausgleichsventil angeordnet ist.

9. Schaltschrankanordnung nach Anspruch 7, bei der der fluidische Übergang vom Innern des mindestens einen Gehäuses (1) zur Umgebung des mindestens einen Gehäuses (1) gasdurchlässig und in entgegengesetzter Richtung gasundurchlässig ist.

10. Schaltschrankanordnung nach einem der vorangegangenen Ansprüche, bei der mehrere Gehäuse (1) eine Schaltschrankreihe mit fluidisch untereinander verbundenen Gehäusen (1), wobei die beiden mikroporösen Membranen (5) in der Außenwand (4) unterschiedlicher Gehäuse (1) der Schaltschrankreihe angeordnet ist.

11. Schaltschrankanordnung nach einem der vorangegangenen Ansprüche, bei der das Löschmittel Perfluor(2-methyl-3-pentanon) ist oder aufweist.

12. Schaltschrankanordnung nach einem der vorangegangenen Ansprüche, bei der die Löschanlage (3) eine Löschmitteldosierung aufweist, die dazu eingerichtet ist, im Löschfall eine Menge Löschmittel, vorzugsweise Perfluor(2-methyl-3-pentanon), in das Innere der Schaltschrankanordnung zu dosieren, die im Innern des mindestens einen Gehäuses (1) einen atmosphärischen Überdruck gegenüber der Umgebung der Schaltschrankanordnung von mindestens 25 mbar, vorzugsweise von mindestens 35 mbar und besonders bevorzugt von mindestens 40 mbar erzeugt.

13. Schaltschrankanordnung nach Anspruch 12, bei der die Membran (5) dazu eingerichtet ist, den Überdruck für mindestens 3 Minuten zu halten, vorzugsweise für mindestens 5 Minuten und besonders bevorzugt für mindestens 12 Minuten.

14. Schaltschrankanordnung nach einem der vorangegangenen Ansprüche, bei der eine Konzentration des Löschmittels im Löschfall mindestens 5 %, bevorzugt mindestens 6 % und besonders bevorzugt mindestens 8 % beträgt, wobei die Membran (5) dazu eingerichtet ist, die Konzentration vorzugsweise für mindestens 3 Minuten zu halten, vorzugsweise für mindestens 5 Minuten und besonders bevorzugt für mindestens 12 Minuten.

15. Schaltschrankanordnung nach einem der vorangegangenen Ansprüche, bei der im Innern des Gehäuses (1) ein Prallblech einem Löschmittelauslass der Löschanlage (3) vorgelagert angeordnet ist.

## Claims

1. Switchgear cabinet assembly comprising at least one housing (1) and at least one electrochemical energy store (2) accommodated therein and having an extinguishing system (3), wherein at least two outer walls (4) of the at least one housing (1) have arranged diametrically opposite them in each case at least one gas-permeable membrane (5), via which a gas atmosphere in the interior of the at least one housing (1) is fluidically connected to a gas atmosphere in the surroundings of the at least one housing (1), wherein a gas permeability of the membrane is set such that a gas of an extinguishing agent of the extinguishing system (3), which has larger molecules in comparison with hydrogen, cannot pass through the membrane.

2. Switchgear cabinet assembly according to claim 1, in which the gas-permeable membranes (5) are permeable to at least hydrogen gas (H₂) and impermeable to liquid, in particular water.

3. Switchgear cabinet assembly according to claim 1 or 2, in which the membrane (5) has or consists of a microporous expanded polytetrafluoroethylene (ePTFE).

4. Switchgear cabinet assembly according to one of the preceding claims, in which the gas-permeable membrane (5) has a multiplicity of fibrils with a diameter which is many times smaller than the diameter of a water drop.

5. Switchgear cabinet assembly according to one of the preceding claims, in which the at least one membrane (5) in each case at an overpressure of 10-12 mbar in the interior of the switchgear cabinet assembly has a gas permeability to air of at least 14 I/min with respect to the surroundings of the switchgear cabinet assembly.

6. Switchgear cabinet assembly according to one of the preceding claims, in which the gas-permeable membrane (5) is permeable to hydrogen gas (H₂) and substantially impermeable to an extinguishing gas of the extinguishing system (3), preferably to long-chain carbon compounds, particularly preferably to the gas of perfluoro(2-methyl-3-pentanone) (C₆F₁₂O).

7. Switchgear cabinet assembly according to claim 1, in which the gas permeability to hydrogen is at least 5 times, preferably at least 10 times greater than for the extinguishing gas.

8. Switchgear cabinet assembly according to one of the preceding claims, in which the gas-permeable membrane (5) is arranged in a fluidic transition of a pressure compensation valve.

9. Switchgear cabinet assembly according to claim 7, in which the fluidic transition from the interior of the at least one housing (1) to the surroundings of the at least one housing (1) is gas-permeable and gas-impermeable in the opposite direction.

10. Switchgear cabinet assembly according to one of the preceding claims, in which a plurality of housings (1) form a switchgear cabinet row with housings (1) fluidically connected to one another, wherein the two microporous membranes (5) are arranged in the outer wall (4) of different housings (1) of the switchgear cabinet row.

11. Switchgear cabinet assembly according to one of the preceding claims, in which the extinguishing agent is or has perfluoro(2-methyl-3-pentanone).

12. Switchgear cabinet assembly according to one of the preceding claims, in which the extinguishing system (3) has an extinguishing agent metering unit which is set up, in the event of extinguishing, to meter an amount of extinguishing agent, preferably perfluoro(2-methyl-3-pentanone), into the interior of the switchgear cabinet assembly, which extinguishing agent metering unit in the interior of the at least one housing (1) generates an atmospheric overpressure with respect to the surroundings of the switchgear cabinet assembly of at least 25 mbar, preferably of at least 35 mbar and particularly preferably of at least 40 mbar.

13. Switchgear cabinet assembly according to claim 12, in which the membrane (5) is set up to keep the overpressure for at least 3 minutes, preferably for at least 5 minutes and particularly preferably for at least 12 minutes.

14. Switchgear cabinet assembly according to one of the preceding claims, in which a concentration of the extinguishing agent in the event of extinguishing is at least 5%, preferably at least 6% and particularly preferably at least 8%, wherein the membrane (5) is set up to keep the concentration preferably for at least 3 minutes, preferably for at least 5 minutes and particularly preferably for at least 12 minutes.

15. Switchgear cabinet assembly according to one of the preceding claims, in which a baffle plate is arranged in the interior of the housing (1) upstream of an extinguishing agent outlet of the extinguishing system (3).

## Revendications

1. Dispositif d'armoire de commande comprenant au moins un boîtier (1) et au moins un accumulateur d'énergie électrochimique (2) logé dans celui-ci et un dispositif d'extinction (3), au moins une membrane perméable au gaz (5) étant agencée sur au moins deux parois extérieures (4) diamétralement opposées à un ou des boîtiers (1), par l'intermédiaire de laquelle une atmosphère gazeuse à l'intérieur du ou des boîtiers (1) est en communication fluidique avec une atmosphère gazeuse dans l'environnement du ou des boîtiers (1), la perméabilité au gaz de la membrane étant réglée de telle sorte qu'un gaz d'un agent d'extinction du dispositif d'extinction (3), qui présente des molécules plus grosses que l'hydrogène, ne puisse traverser la membrane.

2. Dispositif d'armoire de commande selon la revendication 1, dans lequel les membranes perméables aux gaz (5) sont perméables au moins à l'hydrogène gazeux (H₂) et imperméables aux liquides, en particulier à l'eau.

3. Dispositif d'armoire de commande selon la revendication 1 ou 2, dans lequel la membrane (5) comprend un polytétrafluoroéthylène expansé microporeux (ePTFE) ou est constituée de celui-ci.

4. Dispositif d'armoire de commande selon l'une des revendications précédentes, dans lequel la membrane perméable aux gaz (5) présente une multitude de micro-alvéoles dont le diamètre est plusieurs fois inférieur au diamètre d'une goutte d'eau.

5. Dispositif d'armoire de commande selon l'une des revendications précédentes, dans lequel la ou les membranes (5) présentent, à une surpression de 10-12 mbar à l'intérieur du dispositif d'armoire de commande par rapport à l'environnement du dispositif d'armoire de commande, une perméabilité à l'air d'au moins 14 l/min.

6. Dispositif d'armoire de commande selon l'une des revendications précédentes, dans lequel la membrane perméable aux gaz (5) est perméable à l'hydrogène gazeux (H₂) et essentiellement imperméable à un gaz d'extinction du dispositif d'extinction (3), de préférence aux composés de carbone gazeux à longue chaîne, et de manière particulièrement préférable au gaz perfluoro(2-méthyl-3-pentanone) (C₆F₁₂O).

7. Dispositif d'armoire de commande selon la revendication 1, dans lequel la perméabilité à l'hydrogène est au moins 5 fois, de préférence au moins 10 fois supérieure à celle du gaz d'extinction.

8. Dispositif d'armoire de commande selon l'une des revendications précédentes, dans lequel la membrane perméable aux gaz (5) est agencée dans un passage fluidique d'une soupape de compensation de pression.

9. Dispositif d'armoire de commande selon la revendication 7, dans lequel le passage fluidique de l'intérieur du ou des boîtiers (1) vers l'environnement du ou des boîtiers (1) est perméable aux gaz, et imperméable aux gaz dans le sens opposé.

10. Dispositif d'armoire de commande selon l'une des revendications précédentes, dans lequel plusieurs boîtiers (1) forment une rangée d'armoires de commande avec des boîtiers (1) reliés entre eux de manière fluidique, les deux membranes microporeuses (5) étant agencées dans la paroi extérieure (4) de différents boîtiers (1) de la rangée d'armoires de commande.

11. Dispositif d'armoire de commande selon l'une des revendications précédentes, dans lequel l'agent extincteur est le perfluoro(2-méthyl-3-pentanone) ou contient celui-ci.

12. Dispositif d'armoire de commande selon l'une des revendications précédentes, dans lequel le dispositif d'extinction (3) comprend un dosage d'agent extincteur qui est conçu pour doser, dans un cas d'extinction, une quantité d'agent extincteur, de préférence du perfluoro(2-méthyl-3-pentanone), à l'intérieur de l'agencement d'armoire de commande, qui génère à l'intérieur du ou des boîtiers (1) une surpression atmosphérique par rapport à l'environnement du dispositif d'armoire de commande d'au moins 25 mbar, de préférence d'au moins 35 mbar et de manière particulièrement préférable d'au moins 40 mbar.

13. Ensemble d'armoire de commande selon la revendication 12, dans lequel la membrane (5) est conçue pour maintenir la surpression pendant au moins 3 minutes, de préférence pendant au moins 5 minutes et de manière particulièrement préférable pendant au moins 12 minutes.

14. Dispositif d'armoire de commande selon l'une des revendications précédentes, dans lequel la concentration de l'agent extincteur dans un cas d'extinction est d'au moins 5 %, de préférence d'au moins 6 % et de manière particulièrement préférable d'au moins 8 %, la membrane (5) étant conçue pour maintenir la concentration de préférence pendant au moins 3 minutes, de préférence pendant au moins 5 minutes et de manière particulièrement préférable pendant au moins 12 minutes.

15. Dispositif d'armoire de commande selon l'une des revendications précédentes, dans lequel une chicane est agencée à l'intérieur du boîtier (1) en amont d'une sortie d'agent extincteur du dispositif d'extinction (3).
